# EUROPÄISCHE PATENTSCHRIFT

(11) **EP 3 056 587 B1**
(45) Veröffentlichungstag und Bekanntmachung des Hinweises auf die Patenterteilung: **18.11.2020**
(21) Anmeldenummer: 15155026.6
(22) Anmeldetag: 13.02.2015
(51) Int. Cl.: B23C 5/16, C23C 14/34, C23C 14/35, C23C 14/06, C23C 28/04, H01J 37/34, C23C 30/00, C23C 28/00

(54) **VHM-Schaftfräser mit TiAlN-ZrN-Beschichtung**
VHM end mill with TiAlN-ZrN coating
Fraise à queue VHM dotée d'un revêtement en TiAlN-ZrN

(43) Veröffentlichungstag der Anmeldung: 17.08.2016
(73) Patentinhaber: Walter AG, 72072 Tübingen (DE)
(72) Erfinder: Engelhart, Wolfgang, 72555 Metzingen (DE); Schier, Veit, 70771 Echterdingen (DE)
(74) Vertreter: Sandvik

(56) Entgegenhaltungen:
- EP-A2- 1 762 638
- DE-A1-102010 039 035
- DE-A1-102011 117 994
- DE-A1-102012 109 254
- US-B2- 7 758 975
- US-B2- 8 709 583

## Beschreibung

### Gegenstand der Erfindung

Die vorliegende Erfindung betrifft ein Verfahren zur Herstellung eines Vollhartmetallfräsers (VHM-Fräser) mit einem Substrat aus Hartmetall und einer wenigstens auf den beim Fräsvorgang mit einem Werkstück in Kontakt tretenden Oberflächenbereichen im PVD-Verfahren aufgebrachten mehrlagigen Beschichtung, wobei die mehrlagige Beschichtung eine unmittelbar auf der Substratoberfläche abgeschiedene ein- oder mehrlagige Funktionsschicht und eine darüber abgeschiedene ein- oder mehrlagige Deckschicht umfasst.

### Hintergrund der Erfindung

Schneidwerkzeuge wie solche, die beispielsweise zur spanabhebenden Metallbearbeitung eingesetzt werden, bestehen in der Regel aus einem Substrat (Grundkörper) aus Hartmetall, Cermet, Stahl oder Schnellarbeitsstahl mit einer darauf mittels CVD-Verfahren (Chemische Gasphasenabscheidung) oder PVD-Verfahren (Physikalische Gasphasenabscheidung) abgeschiedenen verschleißbeständigen ein- oder mehrlagigen Beschichtung aus metallischen Hartstofflagen. Bei den PVD-Verfahren unterscheidet man zwischen verschiedenen Varianten, beispielsweise Kathodenzerstäubung (Sputter-Abscheidung), kathodisches Vakuum-Lichtbogenverdampfen (Arc-PVD), lonenplattierung, Elektronenstrahlverdampfung und Laserablation. Kathodenzerstäubung, wie Magnetronsputtern, reaktives Magnetronsputtern oder High Power Impulse Magnetronsputtern (HIPIMS), und das Lichtbogenverdampfen zählen zu den am häufigsten für die Beschichtung von Schneidwerkzeugen angewendeten PVD-Verfahren.

Für das Fräsen mit beschichteten Vollhartmetallfräsern, insbesondere das Stirnfräsen in Stahlwerkstoffen, ist es für das Erzielen guter Fräsergebnisse und Standzeiten besonders wichtig, dass die Beschichtung eine hohe Haftung und niedrige Oberflächenrauheit aufweist. Die Beschichtungsqualität hängt neben der Zusammensetzung unter anderem sehr stark von den angewendeten Beschichtungsverfahren ab, wobei die meisten Verfahren vor und Nachteile haben, die je nach Werkzeugart, Substratmaterial und Anwendungsgebiet unterschiedlich stark zum Tragen kommen.

Beim kathodischen Vakuum-Lichtbogenverdampfen (Arc-PVD) brennt zwischen der Kammer und dem Target ein Lichtbogen, der das Targetmaterial schmilzt und verdampft. Dabei wird ein großer Teil des verdampften Materials ionisiert und zu dem mit einem negativen Potential (Biaspotential) belegten Substrat hin beschleunigt und auf der Substratoberfläche abgeschieden. Das kathodische Vakuum-Lichtbogenverdampfen (Arc-PVD) zeichnet sich durch eine hohe Beschichtungsrate, dichte Schichtstrukturen, bedingt durch die hohe Ionisation des verdampften Materials, sowie Prozessstabilität aus. Aufgrund der hohen Metallionisierung erzielt man durch das kathodische Vakuum-Lichtbogenverdampfen (Arc-PVD) eine gute Schichtanbindung bzw. Haftung der abgeschiednenen Schicht auf dem Untergrund. Ein wesentlicher Nachteil ist jedoch die verfahrensbedingte Abscheidung von Makropartikeln (Droplets), verursacht durch die Emission von kleinen Metallspritzern, deren Vermeidung äußerst aufwendig ist. Die Droplets führen zu einer unerwünscht hohen Oberflächenrauheit auf den abgeschiedenen Lagen. Dies führt in einigen Anwendungen wiederum zu einem früheren Verschleiß des Werkzeugs durch verstärktes Anhaften der Werkzeugoberfläche an dem Werkstück, erhöhte Reibungskräfte und dadurch bedingt erhöhte Schnittkräfte.

Bei der Kathodenzerstäubung (Sputtern) werden aus dem Target durch Beschuss mit energiereichen Ionen, Atome oder Moleküle herausgelöst und in die Gasphase überführt, wo sie dann entweder direkt oder nach Umsetzung mit einem Reaktionsgas auf dem Substrat abgeschieden werden. Das Magnetron-unterstützte Kathodenzerstäuben umfasst zwei wesentliche Prozessvarianten, das klassische DC-Magnetronsputterns (DC-MS) und das HIPIMS Verfahren. Beim Magnetronsputtern tritt die beim kathodischen Vakuum-Lichtbogenverdampfen (Arc-PVD) nachteilige Dropletbildung nicht auf. Jedoch sind beim klassischen DC-MS die Beschichtungsraten im Vergleich zum kathodischen Vakuum-Lichtbogenverdampfen (Arc-PVD) vergleichsweise niedrig, was höhere Prozessdauern und damit einen ökonomischen Nachteil bedeutet.

Beim High Power Impulse Magnetronsputtern (HIPIMS) wird der Magnetron im gepulsten Modus mit hohen Stromdichten betrieben, was zu einer verbesserten Schichtstruktur in Form von dichteren Schichten, insbesondere Aufgrund einer verbesserten Ionisation des abgesputterten Materials, führt. Die Stromdichten am Target übersteigen beim HIPIMS typischerweise die des klassischen DC-MS. Mittels HIPIMS kann je nach Material eine bis zu 100%-ige Ionisierung der gesputterten Teilchen erzielt werden. Dabei führen die kurzzeitig hohen auf das Target einwirkenden Leistungen bzw. Entladestromdichten zu dem erhöhten Ionisierungsgrad, welcher den Wachstumsmechanismus und die Anbindung der Schichten auf dem Untergrund verändern kann und somit Einfluss auf die Schichteigenschaften hat.

Mittels DC-MS und HIPIMS abgeschiedene Schichten weisen häufig deutliche strukturelle Unterschiede auf. DC-MS-Schichten wachsen in der Regel in einer kolumnaren Struktur auf dem Untergrund auf. Beim HIPIMS-Verfahren können hingegen feinkristalline als auch grobkristalline Schichtstrukturen erzielt werden, die sich im Vergleich zu DC-MS-Schichten durch ein verbessertes Verschleißverhalten und damit verbundene längere Standzeiten auszeichnen. HIPIMS-Schichten sind in der Regel härter als DC-MS-Schichten, zeigen aber auch Nachteile hinsichtlich ihrer Haftung auf vielen Untergründen.

Typische Peak-Leistungsdichten beim konventionellen HIPIMS-Verfahren liegen im Bereich von 20 W/cm². Unter Verwendung von besonderen Targetkühleinrichtungen können bis zu 50 W/cm² erreicht werden. Die entsprechenden Entladestromdichten liegen dabei im Bereich von bis zu 0.2 A/cm². Theoretisch wären jedoch weit höhere Leistungsdichten und damit Entladestromdichten möglich, jedoch ist die auf ein Sputtertarget anwendbare mittlere Leistung durch die begrenzten Möglichkeiten der Targetkühlung limitiert. Daher wird die Sputterleistung in gepulster Form angelegt, wobei die Pulsdauer so kurz gewählt wird, dass es aufgrund der mittleren auf das Target einwirkenden Leistung nicht zur Übertemperatur kommt, wobei die Targettemperatur und die zulässige maximale Targettemperatur sehr stark vom Targetmaterial und dessen Wärmeleitfähigkeit und mechanischen Eigenschaften abhängen. Nachteilig dabei ist, dass die Pulstechnologie zu einem erheblichen apparativen Aufwand führt, da Generatoren verwendet werden müssen, welche in der Lage sind die Leistung zeitlich und räumlich in Sputter-Leistungspulse aufzuteilen. Dies wird von der konventionellen Generator-Technologie nicht geleistet. Im Stand der Technik werden verschiedene Lösungen für dieses Problem angeboten, z. B. in (US 6 413 382 und WO 03/006 703, die jedoch mit Nachteilen behaftet sind.

Die WO 2012/143087 beschreibt ein HIPIMS-Verfahren mit dem es möglich ist, Material von einer Targetoberfläche so zu zerstäuben, dass das zerstäubte Material zu einem hohen Prozentsatz ionisiert vorliegt. Dies wird mittels eines einfachen Generators erreicht, dessen Leistung in Zeitintervallen verteilt in mehrere Magnetron-Sputterquellen eingespeist wird, d. h. eine Sputterquelle zu einem Zeitintervall mit maximaler Leistung versorgt wird und die nächste Sputterquelle im sich anschließenden Zeitintervall mit maximaler Leistung versorgt wird. Auf diese Weise werden hohe Entladungsstromdichten realisiert. Die Pulsleistung liegt nur zeitweise an den einzelnen Kathoden an, so dass diese in der Zwischenzeit die Möglichkeit haben abzukühlen und das Temperaturlimit nicht überschritten wird.

Die WO 2013/068080 beschreibt ein Verfahren zum Herstellen eines Schichtsystems mittels HIPIMS, bei dem durch alternierende Anwendung längerer und kürzerer Pulsdauern HIPIMS-Schichten mit abwechselnd feinerer und gröberer Körnigkeit abgeschieden werden. Ein solches Wechselschichtsystem soll gute Verschleißeigenschaften aufweisen.

Die US 8,709,583 B2 beschreibt ein Schneidwerkzeug mit ein Grundkörper aus Hartmetall und einer darauf angebrachten mehrlagigen Beschichtung. Die Beschichtung weist eine erste Lage aus TiAIN und eine zweite Lage aus Aluminiumoxid auf. Weiter zusätzlich n alternierend übereinander aufgebrachte Lagen aus TiAIN und Lagen aus Aluminiumoxid wobei n eine gerade Zahl von 0 bis 10 ist. Weiter optional eine äussere Lage aus ZrN.

Die US 7,758,975 B2 beschreibt eine PVD-Beschichtung für Schneidwerkzeuge die aus zwei metallischen Hartstoffschichten unterschiedlicher Farbe besteht, z.B., TiAIN und ZrN. Zwischen die zwei Hartstoffschichten ist eine Trennschicht angeordnet.

Die DE 10 2012 109254 A1 beschreibt einen im PVD-Verfahren aufgebrachten mehrlagigen Beschichtung die wenigstens eine lage aus TiAIN und wenigstens eine Lage aus einer abfolge von wenigstens 4 abwechselnd übereinander angeordneten Sub-Lagen TiSiN und AICrN umfasst. Die DE 10 2010 039035 A1 beschreibt ein Schneidwerkzeug mit einen Grundkörper und einer darauf aufgebrachten mehrlagigen Beschichtung. Die Beschichtung weist eine erste Lage A auf welcher unter TiAlN, TiAlSiN, CrN, AlCrN, AlCrSiN und ZrN ausgewählt ist, und unmittelbar über der ersten Lage A eine zweite Lage B aus Si₃N₄ aufgebracht ist.

Die DE 10 2011 117994 A1 beschreibt ein Verfahren zum Abscheiden von PVD-Schichtsystemen dadurch gekennzeichnet dass zumindest in einem Schritt des Verfahrens ein HIPIMS Verfahren angewandt wird mit einer Leistungdichte von zumindest 250 W/cm².

### Aufgabe der Erfindung

Die Aufgabe der vorliegenden Erfindung bestand darin, einen beschichteten Vollhartmetallfräser (VHM-Fräser), insbesondere für das Schaftfräsen, bereitzustellen, welcher sich gegenüber dem Stand der Technik durch eine hohe Haftung der Beschichtung, geringe Oberflächenrauheit, hohe Verschleißbeständigkeit und damit verbundene höhere Standzeiten auszeichnet.

### Beschreibung der Erfindung

Gelöst wird diese Aufgabe erfindungsgemäß durch ein Verfahren zur Herstellung eines Vollhartmetallfräsers (VHM-Fräser) gemäß Anspruch 1 (VHM-Fräser) mit einem Substrat aus Hartmetall und einer wenigstens auf den beim Fräsvorgang mit einem Werkstück in Kontakt tretenden Oberflächenbereichen im PVD-Verfahren aufgebrachten mehrlagigen Beschichtung, wobei die mehrlagige Beschichtung eine unmittelbar auf der Substratoberfläche abgeschiedene ein- oder mehrlagige Funktionsschicht und eine darüber abgeschiedene ein- oder mehrlagige Deckschicht umfasst, wobei
die Funktionsschicht aus einer oder mehreren Lagen von TiₓAl₁₋ₓN mit 0,3 ≤ x ≤ 0,55 besteht und eine Gesamtdicke von 1 µm bis 15 µm aufweist,
die Deckschicht aus einer oder mehreren Lagen von ZrN besteht und eine Gesamtdicke von 50 nm bis 1 µm aufweist und
die Funktionsschicht und die Deckschicht mittels High Power Impulse Magnetronsputtern (HIPIMS) abgeschieden sind,
wobei bei der Abscheidung der Funktionsschicht jedes Sputtertarget aus abzuscheidendem Material in der Beschichtungskammer mit Leistungspulsen beaufschlagt wird, welche eine Energiemenge auf das Sputtertarget übertragen, die eine maximale Leistungsdichte im Puls von ≥ 500 W/cm² übersteigt.

In einer bevorzugten Ausführungsform der Erfindung sind die Funktionsschicht und die Deckschicht mittels High Power Impulse Magnetronsputtern (HIPIMS) abgeschieden, wobei bei der Abscheidung der Funktionsschicht jedes Sputtertarget aus abzuscheidendem Material in der Beschichtungskammer mit Leistungspulsen beaufschlagt wird, welche eine Energiemenge auf das Sputtertarget übertragen, die eine maximale Leistungsdichte im Puls von ≥ 1000 W/cm² übersteigt.

In einer weiteren bevorzugten Ausführungsform der Erfindung sind die Funktionsschicht und die Deckschicht mittels High Power Impulse Magnetronsputtern (HIPIMS) abgeschieden, wobei bei der Abscheidung der Funktionsschicht jedes Sputtertarget aus abzuscheidendem Material in der Beschichtungskammer mit Leistungspulsen mit Entladungsstromdichten im Puls ≥ 1 A/cm², vorzugsweise ≥ 3 A/cm² beaufschlagt wird.

Der Begriff "ein- oder mehrlagige" Funktionsschicht bedeutet im Sinne der vorliegenden Erfindung, dass die Funktionsschicht aus einer einzelnen oder mehreren übereinander angeordneten Lagen von TiₓAl₁₋ₓN mit 0,3 ≤ x ≤ 0,55 besteht. Besteht die Funktionsschicht aus mehreren übereinander angeordneten Lagen von TiₓAl₁₋ₓN, so sind diese vorzugsweise von einem oder mehreren Targets gleicher Zusammensetzung abgeschieden, beispielsweise Targets mit der Zusammensetzung Ti₄₀Al₆₀, so dass die mehreren übereinander angeordneten Lagen die gleiche Stöchiometrie von TiₓAl₁₋ₓN aufweisen. Eine solche Funktionsschicht ist im Sinne der vorliegenden Erfindung mehrlagig, wenn die Funktionsschicht in mehreren Stufen des HIPIMS-Verfahrens mit unterschiedlichen Abscheidungsparametern abgeschieden wurden. Eine mehrlagige Funktionsschicht im Sinne der vorliegenden Erfindung kann jedoch auch mehrere übereinander angeordnete TiₓAl₁₋ₓN-Lagen mit unterschiedlichen Stöchiometrien aufweisen.

Der Begriff "ein- oder mehrlagige" Deckschicht bedeutet im Sinne der vorliegenden Erfindung, dass die Deckschicht aus einer einzelnen oder mehreren übereinander angeordneten Lagen von ZrN besteht. Besteht die Deckschicht aus mehreren übereinander angeordneten Lagen von ZrN, so sind diese von einem oder mehreren Zr-Targets abgeschieden, jedoch in mehreren Stufen des HIPIMS-Verfahrens mit unterschiedlichen Abscheidungsparametern.

Die erfindungsgemäß mittels HIPIMS-Verfahren abgeschiedene Beschichtung zeichnet sich gegenüber bekannten Beschichtungen von Vollhartmetallfräsern durch eine besonders hohe Haftung (Schichtanbindung auf dem Substrat), geringe Oberflächenrauheit und hohe Verschleißbeständigkeit und damit verbunden durch hohe Standzeiten des Werkzeugs aus. Es wird angenommen, dass die besonders gute Haftung der Beschichtung auf dem Substrat daraus resultiert, dass bereits zu Beginn des HIPIMS-Beschichtungsverfahrens bei der Abscheidung der Funktionsschicht Atome bzw. Ionen mit besonders hoher Energie auf die Substratoberfläche auftreffen. Die Beschichtung besitzt feine Schichtstrukturen sowie hohe Härten und hohe Elastizitätsmodule (E-Module). Hohe Härte und hoher E-Modul sind in vielen Metallbearbeitungsverfahren vorteilhaft. Die Härte der im HIPIMS-Verfahren abgeschiedenen Schichten kann durch die Beschichtungsparameter beeinflusst werden, insbesondere durch Einstellen des Biaspotentials und der Pulsart. Ein hohes Biaspotential führt in der Regel zu einer Steigerung der Härte.

In einer Ausführungsform der Erfindung weist die Funktionsschicht eine Vickers-Härte im Bereich von 2500 HV bis 4500 HV auf, vorzugsweise im Bereich von 3000 HV bis 4000 HV. Die Härtemessungen wurden mit einem Härtemessgerät PICODENTOR® HM500 der Firma Helmut Fischer GmbH, Sindelfingen-Maichingen, Deutschland, unter Verwendung einer Vickers-Pyramide mit einer maximalen Last von 15 mN, einer Be- und Entlastungsdauer von 20 sek und einer Haltedauer der Last von 5 sek durchgeführt. Die Auswertung der Messungen erfolgte nach der Oliver-Pharr-Methode.

In einer weiteren Ausführungsform der Erfindung weist die Funktionsschicht einen Elastizitätsmodul (E-Modul) im Bereich von 350 GPa bis 550 GPa auf, vorzugsweise von 400 GPa bis 500 GPa. Als E-Modul wird hier der reduzierte E-Modul bzw. Eindringmodul EIT/(1-v²) angegeben.

Die erfindungsgemäß mittels HIPIMS abgeschiedene Beschichtung weist eine deutlich glattere Oberfläche auf als beispielsweise eine mittels Arc-PVD abgeschiedene Beschichtung. Dies hat erhebliche Vorteile, insbesondere weniger Anhaften der Werkzeugoberfläche an dem Werkstück, geringere Reibungskräfte und dadurch bedingt geringere Schnittkräfte, aber auch eine bessere Spanabführung.

In einer weiteren Ausführungsform der Erfindung weist die ein- oder mehrlagige Funktionsschicht eine Gesamtdicke von 1 µm bis 10 µm, vorzugsweise von 1,5 µm bis 5 µm, besonders bevorzugt von 2 µm bis 3,5 µm auf. Ist die Funktionsschicht zu dünn, wird die gewünschte Wirkung der Schicht nicht erzielt, nämlich insbesondere der Verschleißschutz. Ist die Funktionsschicht zu dick, kommt es häufiger zu Abplatzungen im Kantenbereich, was sich nachteilig auf die Standzeit des Werkzeugs auswirkt.

In einer weiteren Ausführungsform der Erfindung weist die ein- oder mehrlagige Deckschicht eine Gesamtdicke von 50 nm bis 500 nm, vorzugsweise von 70 nm bis 250 nm, besonders bevorzugt von 80 nm bis 150 nm auf.

Die Deckschicht hat eine dekorative Funktion und sie dient auch der Verschleißerkennung, d. h. sie zeigt durch entsprechende Abnutzung an, ob und mit welchem Verschleiß das Werkzeug bereits benutzt wurde. Sofern über der Deckschicht keine weiteren Schichten angeordnet sind, verleiht die ZrN-Deckbeschichtung dem Werkzeug eine goldgelbe Farbe, die durch Einstellen der HIPIMS-Verfahrensparameter zwischen unterschiedlichen Farbtönen variiert werden kann. Beispielsweise kann durch die jeweilige Einstellung des Stickstoffpartialdrucks im HIPIMS-Verfahren die Helligkeit des goldgelben Farbtons variiert werden. Das Abscheiden der Deckschicht im HIPIMS-Verfahren wie die TiAIN-Schicht hat Vorteile bei der Verfahrensführung von der Abscheidung der Funktionsschicht bis zur Deckschicht. Ein wesentlicher weiterer Vorteil ist jedoch die damit verbundene geringe Oberflächenrauheit bzw. die besonders glatte Oberfläche der Deckschicht mit den oben beschriebenen Vorteilen. Darüber hinaus hat das Vorsehen der ZrN-Deckschicht tribochemische Vorteile bei der Zerspanung, insbesondere von Titanlegierungen, die beispielsweise in der Luft- und Raumfahrtindustrie eingesetzt werden, und von rostfreien Stählen. Für die Abscheidung der Deckschicht ist es erfindungsgemäß nicht erforderlich, dass auf die Sputtertargets des abzuscheidenden Materials für die Deckschicht die hohen für Abscheidung der Funktionsschicht erforderlichen Energiemengen mit einer maximalen Leistungsdichte im Puls von ≥ 500 W/cm² auf das Sputtertarget übertragen werden.

Die erfindungsgemäße Funktionsschicht besteht aus einer einzelnen oder mehreren übereinander angeordneten Lagen von TiₓAl₁₋ₓN mit 0,3 ≤ x ≤ 0,55. In einer weiteren Ausführungsform der Erfindung ist 0,35 ≤ x ≤ 0,45, besonders bevorzugt ist x etwa 0,4.

In einer weiteren Ausführungsform der Erfindung weist das Substrat aus Hartmetall eine Zusammensetzung mit 9 bis 14 Gew.-% Co, vorzugsweise 10 bis 13 Gew.-% Co, besonders bevorzugt 11,5 bis 12,5 Gew.-% Co, und 0 bis 1,5 Gew.-%, vorzugsweise 0 bis 1,0 Gew.-%, besonders bevorzugt 0 bis 0,5 Gew.-% kubischen Karbiden, ausgewählt unter TiC, TaC und NbC, und als Rest WC auf.

Des Weiteren ist es erfindungsgemäß vorteilhaft, wenn das WC in dem Substrat aus Hartmetall eine mittlere Korngröße von 0,5 bis 5 µm, vorzugsweise eine mittlere Korngröße von 1,0 bis 3,0 µm, besonders bevorzugt eine mittlere Korngröße von 1,0 bis 2,0 µm aufweist. Hartmetalle mit WC-Korngrößen im vorgenannten Bereich werden auch als Feinkornsorten bezeichnet. In Verbindung mit einem hohen Co-Gehalt, wie zuvor beschrieben, liefert eine solche Feinkornsorte ein Werkzeug mit hoher Härte und Zähigkeit, die insbesondere für das Schaftfräsen von nach ISO 513 charakterisierten ISO-P-Werkstoffen (unlegierter oder legierter Stahl, Stahlguss, rostfreier ferritischer oder martensitischer Stahl, langspanender Temperguss) und ISO-M-Werkstoffen (nichtrostender Stahl, Stahlguss, Manganstahl, legierter Grauguss, rostfreier austenitischer Stahl, gegossener Temperguss, Automatenstahl) vorteilhaft sind.

In einer bevorzugten Ausführungsform der Erfindung ist der Vollhartmetallfräser als Schaftfräser, besonders bevorzugt als Stirnfräser ausgebildet. Beim Schaftfräsen, insbesondere beim Stirnfräsen ist die erfindungsgemäße Beschichtung besonders vorteilhaft, da diese Anwendungen besonders hohe Anforderungen an niedrige Oberflächenrauheit des Werkzeugs und hohe Schichtanbindung stellen, welche das erfindungsgemäße Werkzeug erfüllt.

Die Erfindung umfasst ein Verfahren zur Herstellung des hierin beschriebenen beschichteten Vollhartmetallfräsers mit den Stufen, in denen man
ein Substrat aus Hartmetall wenigstens auf den beim Fräsvorgang mit einem Werkstück in Kontakt tretenden Oberflächenbereichen im PVD-Verfahren mit einer mehrlagigen Beschichtung versieht, wobei die mehrlagige Beschichtung eine unmittelbar auf der Substratoberfläche abgeschiedene ein- oder mehrlagige Funktionsschicht und eine darüber abgeschiedene ein- oder mehrlagige Deckschicht umfasst, wobei man
die Funktionsschicht mittels High Power Impulse Magnetronsputtern (HIPIMS) aus einer oder mehreren Lagen von TiₓAl₁₋ₓN mit 0,3 ≤ x ≤ 0,55 mit einer Gesamtdicke von 1 µm bis 15 µm abscheidet und
die Deckschicht mittels High Power Impulse Magnetronsputtern (HIPIMS) aus einer oder mehreren Lagen von ZrN mit einer Gesamtdicke von 50 nm bis 1 µm abscheidet,
wobei bei der Abscheidung der Funktionsschicht jedes Sputtertarget aus abzuscheidendem Material in der Beschichtungskammer mit Leistungspulsen beaufschlagt wird, welche eine Energiemenge auf das Sputtertarget übertragen, die eine maximale Leistungsdichte im Puls von ≥ 500 W/cm² übersteigt.

In einer bevorzugten Ausführungsform des erfindungsgemäßen Verfahrens wird bei der Abscheidung der Funktionsschicht jedes Sputtertarget aus abzuscheidendem Material in der Beschichtungskammer mit Leistungspulsen beaufschlagt, welche eine Energiemenge auf das Sputtertarget übertragen, die eine maximale Leistungsdichte von ≥ 1000 W/cm² übersteigt.

In einer weiteren bevorzugten Ausführungsform des erfindungsgemäßen Verfahrens wird bei der Abscheidung der Funktionsschicht jedes Sputtertarget aus abzuscheidendem Material in der Beschichtungskammer mit Leistungspulsen mit Entladungsstromdichten ≥ 1 A/cm², vorzugsweise ≥ 3 A/cm² beaufschlagt.

Des Weiteren umfasst die Erfindung die Verwendung des erfindungsgemäßen beschichteten Vollhartmetallfräsers, wie er hierin und in den Ansprüchen definiert ist, definiert ist, zum Schaftfräsen, vorzugsweise zum Stirnfräsen von Stahlwerkstoffen, besonders bevorzugt zum Schaftfräsen oder Stirnfräsen von nach ISO 513 charakterisierten ISO-P-Werkstoffen (unlegierter oder legierter Stahl, Stahlguss, rostfreier ferritischer oder martensitischer Stahl, langspanender Temperguss) und ISO-M-Werkstoffen (nichtrostender Stahl, Stahlguss, Manganstahl, legierter Grauguss, rostfreier austenitischer Stahl, gegossener Temperguss, Automatenstahl) sowie ISO-S-Werkstoffen.

### Beispiele

### Beispiel 1 - Herstellung eines erfindungsgemäßen VHM-Fräsers

Für die Herstellung eines erfindungsgemäßen VHM-Fräsers wurde ein Hartmetallsubstrat einer WC-Feinkornsorte mit 12 Gew.-% Co mit entsprechender Fräsergeometrie (Durchmesser: 10 mm; Anzahl Zähne: 4; Gesamtwerkzeuglänge (Adapter+Werkzeug): 124,3 mm; Auskraglänge des Werkzeugs: 32 mm) im HIPIMS-Verfahren mit einer erfindungsgemäßen mehrlagigen TiAIN-Funktionsschicht und einer mehrlagigen ZrN-Deckschicht beschichtet.

Die Beschichtungen wurden in einer 6-Flansch-PVD-Anlage INGENIA S3p (Oerlikon Balzers Coating AG, Balzers, Liechtenstein) hergestellt. Die Substrate wurden auf Drehtellern rotiert. Für das HIPIMS-Verfahren wurde ein spezieller Plasmagenerator der Firma Oerlikon Balzers verwendet, der die Pulsleistung sequenziell an unterschiedliche Kathoden abgibt. Es wurden Ti₄₀Al₆₀ Targets mit einem Gewicht von jeweils 760 g auf den Reaktorpositionen 4, 5 und 6 sowie Zr-Targets mit einem Gewicht von jeweils 1400 g auf den Reaktorpositionen 1, 2 und 3 eingesetzt. Der N₂-Partialdruck wurde entsprechend den Gewichten der Targets dem Arbeitspunkt angepasst. Die Beschichtungsparameter sind in der nachfolgenden Tabelle 1 wiedergegeben. Die erfindungsgemäße mehrlagige TiAIN-Funktionsschicht hatte eine Gesamtschichtdicke von 2,5 µm und die mehrlagige ZrN-Deckschicht hatte eine Gesamtschichtdicke von 0,3 µm.

Für die TiAIN-Funktionsschicht wurde eine Vickers-Härte von 3500 HV und ein E-Modul von 450 GPa gemessen.

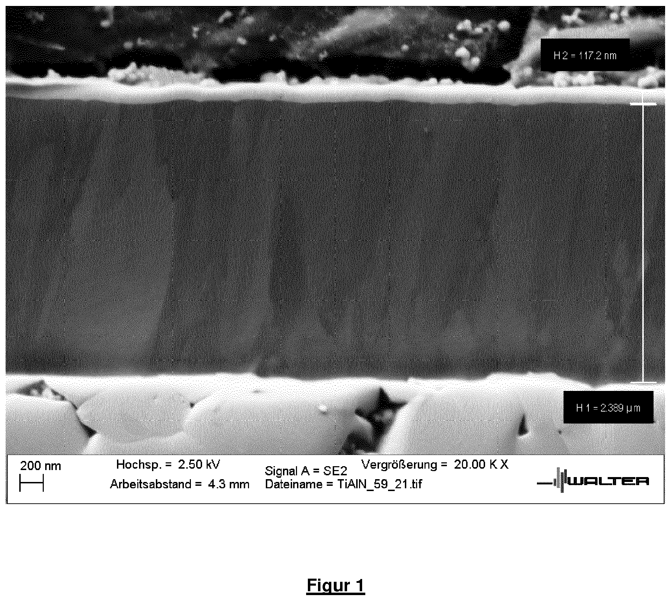

Figur 1 zeigt eine rasterelektronenmikroskopische Aufnahme der Beschichtung im Querschnitt auf einem Substrat für die Laboranalyse.

**Tabelle 1: Beschichtunqsparameter**

| | **Lage 1** | **Lage 2** | **Lage 3** | **Lage 4** | **Lage 5** | **Lage 6** |
|---|---|---|---|---|---|---|
| **Target (aktiv)** | Ti₄₀Al₆₀ | Ti₄₀Al₆₀ | Ti₄₀Al₆₀ | Zr | Zr | Zr |
| **Pulsmuster:** | | | | | | |
| **Tₒₙ [ms]** | 4 | 4 | 4 | 1 | 1 | 1 |
| **T_{del} [ms]** | -0,01 | -0,01 | -0,01 | -0,01 | -0,01 | -0,01 |
| **<Pₚᵤₗₛ> [kW]** | 4,788 | 4,788 | 4,788 | 1,59 | 1,59 | 1,59 |
| | | | | | | |
| **P_{ges, Sputter} [kW]** | 60 | 60 | 60 | 1 | 1 nach 9 | 9 |
| **Ar [Pa]** | 0,43 eingestellt | 0,43 eingestellt | 0,57 eingestellt | 0,55 eingestellt | 0,5 eingestellt | 0,5 eingestellt |
| **N₂ [Pa]** | 0,58 geregelt | 0,55 geregelt | 0,57 geregelt | 0,55 geregelt | 0,5 geregelt | 0,5 geregelt |
| **Bias [-V]** | 40 | 40 | 40 | 40 | 40 | 40 |
| **Dauer [min]** | 40 | 320 | 2 | 0.083 | 4 | 60 |
| **Temperatur [°C]** | 430 | 430 | 430 | 430 | 430 | 430 |

| | | | | | | |
|---|---|---|---|---|---|---|
| **Tₒₙ** bezeichnet die Dauer eines einzelnen Pulses, **T_{del}** bezeichnet die Zeitverschiebung zwischen dem Ende eines Pulses und dem Beginn des folgenden Pulses an einem anderen Target. **P_{ges}, sputter** bezeichnet die Leistung, welche die Pulseinheit aufnimmt "1 nach 9" beschreibt eine eine Rampe von 1 kW bis 9 kW innerhalb der Beschichtungszeit der Lage **Dauer** bezeichnet die Gesamtdauer der Beschichtung der einzelnen Lage; | | | | | | |

Die angegebenen Werte sind Durchschnittswerte, da sich die Plasmabedingungen bei bewegtem Substratteller ständig ändern.

### Vergleichsbeispiel 1 - Herstellung eines VHM-Fräsers mit einlagiger Arc-PVD -Beschichtung

In diesem Vergleichsbeispiel wurde auf dem gleichen Hartmetallsubstrat für einen VHM-Fräser wie in Beispiel 1 eine 2,5 µm dicke, einlagige TiAIN-Schicht mittels Arc-PVD in einer PVD-Anlage INNOVA (Oerlikon Balzers Coating AG, Balzers, Liechtenstein) hergestellt. Dabei wurden folgende Reaktionsparameter angewendet:

| | |
|---|---|
| Targets: | TiAl (44:56), rund, 160 mm Durchmesser, Reaktorpositionen 1 bis 6 |

Abscheideparameter:
Verdampferstrom: 160 A
Gesamtdruck: 4 Pa N₂
Biaspotential: DC, 60 V

Die Arc-PVD-Beschichtung besaß eine gute Anbindung auf dem Substrat, jedoch auch eine vergleichsweise hohe Oberflächenrauheit.

### Vergleichsbeispiel 2 - Herstellung eines VHM-Fräsers mit einlagiger HIPIMS-Beschichtung

In diesem Vergleichsbeispiel wurde auf dem gleichen Hartmetallsubstrat für einen VHM-Fräser wie in Beispiel 1 eine 2,5 µm dicke, einlagige TiAIN-Schicht mittels HIPIMS in einer PVD-Anlage HTC100 (Hauzer, Venlo, Niederlande) hergestellt. Dabei wurden folgende Reaktionsparameter angewendet:

| | |
|---|---|
| Targets: | 2x TiAl (33:67), rechteckig, 1800 x 200 mm, Reaktorpositionen 3 und 6 (gegenüberliegend) |

Abscheideparameter
Durchschnittsleistung: 15 kW (pro Target)
Biaspotential: DC, 100 V
Peakleistung: 200 kW
Peakstrom: 170 A
Pulsfile: Nr. 60
Gesamtdruck: 0,5 Pa N₂/Ar

Die HIPIMS-Beschichtung war sehr glatt (geringe Oberflächenrauheit), besaß aber eine relativ schlechte Anbindung auf dem Substrat.

### Zerspanversuche:

Der gemäß Beispiel 1 hergestellte erfindungsgemäße VHM-Fräser wurde in einem Zerspanversuch mit den VHM-Fräsern gemäß den Vergleichsbeispielen 1 und 2 verglichen.

### Zerspandaten :

| | |
|---|---|
| Schnittgeschwindigkeit (Vc): | 200m/min |
| Zahnvorschub (fz): | 0,075mm |
| Frästiefe (ap): | 9mm |
| Fräsbreite (ae): | 10mm (Vollnuten) |
| Kühlmittel | 20bar (außen) |

Das Abbruchkriterium der Zerspanversuche war ein Flankenverschleiß des Werkzeugs von mehr als 0,2 mm. Die Ergebnisse der Zerspanversuche sind in der nachfolgenden Tabelle 2 als Standwege in Metern angegeben.

**Tabelle 2: Zerspanergebnisse**

| | **Standweg [m]** |
|---|---|
| **Beispiel 1 (Erfindung)** | 63 |
| **Vergleichsbeispiel 1** | 38 |
| **Vergleichsbeispiel 2** | 25 |

## Patentansprüche

1. Verfahren zur Herstellung eines beschichteten Vollhartmetallfräsers mit den Stufen, in denen man
ein Substrat aus Hartmetall wenigstens auf den beim Fräsvorgang mit einem Werkstück in Kontakt tretenden Oberflächenbereichen im PVD-Verfahren mit einer mehrlagigen Beschichtung versieht, wobei die mehrlagige Beschichtung eine unmittelbar auf der Substratoberfläche abgeschiedene ein- oder mehrlagige Funktionsschicht und eine darüber abgeschiedene ein- oder mehrlagige Deckschicht umfasst, wobei man die Funktionsschicht mittels High Power Impulse Magnetronsputtern (HIPIMS) aus einer oder mehreren Lagen von TiₓAl₁₋ₓN mit 0,3 ≤ x ≤ 0,55 mit einer Gesamtdicke von 1 µm bis 15 µm abscheidet und
die Deckschicht mittels High Power Impulse Magnetronsputtern (HIPIMS) aus einer oder mehreren Lagen von ZrN mit einer Gesamtdicke von 50 nm bis 1 µm abscheidet,
wobei bei der Abscheidung der Funktionsschicht jedes Sputtertarget aus abzuscheidendem Material in der Beschichtungskammer mit Leistungspulsen beaufschlagt wird, welche eine Energiemenge auf das Sputtertarget übertragen, die eine maximale Leistungsdichte im Puls von ≥ 500 W/cm² übersteigen.

2. Verfahren nach Anspruch 1, **dadurch gekennzeichnet, dass** bei der Abscheidung der Funktionsschicht jedes Sputtertarget aus abzuscheidendem Material in der Beschichtungskammer mit Leistungspulsen beaufschlagt wird, welche eine Energiemenge auf das Sputtertarget übertragen, die eine maximale Leistungsdichte im Puls von ≥ 1000 W/cm² übersteigen.

3. Verfahren nach Anspruch 1 oder 2, **dadurch gekennzeichnet, dass** bei der Abscheidung der Funktionsschicht jedes Sputtertarget aus abzuscheidendem Material in der Beschichtungskammer mit Leistungspulsen mit Entladungsstromdichten im Puls ≥ 1 A/cm², vorzugsweise ≥ 3 A/cm² beaufschlagt wird.

4. Verfahren nach einem der vorausgehenden Ansprüche, **dadurch gekennzeichnet, dass** die ein- oder mehrlagige Funktionsschicht eine Gesamtdicke von 1 µm bis 10 µm aufweist.

5. Verfahren nach einem der vorausgehenden Ansprüche, **dadurch gekennzeichnet, dass** die ein- oder mehrlagige Deckschicht eine Gesamtdicke von 50 nm bis 500 nm aufweist.

6. Verfahren nach einem der vorausgehenden Ansprüche, **dadurch gekennzeichnet, dass** die Funktionsschicht aus einer oder mehreren Lagen von TiₓAl₁₋ₓN mit 0,35 ≤ x ≤ 0,45 besteht.

7. Verfahren nach einem der vorausgehenden Ansprüche, **dadurch gekennzeichnet, dass** die Funktionsschicht eine Vickers-Härte im Bereich von 2500 HV bis 4500 HV aufweist.

8. Verfahren nach einem der vorausgehenden Ansprüche, **dadurch gekennzeichnet, dass** die Funktionsschicht einen Elastizitätsmodul (E-Modul) im Bereich von 350 GPa bis 550 GPa aufweist.

9. Verfahren nach einem der vorausgehenden Ansprüche, **dadurch gekennzeichnet, dass** das Substrat aus Hartmetall eine Zusammensetzung mit 9 bis 14 Gew.-% Co, und 0 bis 1,5 Gew.-% kubischen Karbiden, ausgewählt unter TiC, TaC und NbC, und als Rest WC aufweist.

10. Verfahren nach einem der vorausgehenden Ansprüche, **dadurch gekennzeichnet, dass** das Substrat aus Hartmetall WC aufweist und das WC eine mittlere Korngröße von 0,5 bis 5 µm hat.

## Claims

1. Method for producing a coated solid carbide milling cutter with the steps in which a substrate consisting of carbide is provided with a multi-layer coating in a PVD process at least on the surface areas that come into contact with a workpiece during the milling operation, wherein the multi-layer coating comprises a single-layer or multi-layer functional layer that is deposited directly on the substrate surface and a single-layer or multi-layer covering layer deposited on top of said functional layer, wherein
the functional layer is deposited by means of high power impulse magnetron sputtering (HIPIMS) in one or more layers of TiₓAl₁₋ₓN with 0.3≤X≤0.55 with an overall thickness of 1 µm to 15 µm and the covering layer is deposited by means of high power impulse magnetron sputtering (HIPIMS) in one or more layers of ZrN with an overall thickness of 50 nm to 1 µm,
wherein, during the deposition of the functional layer, each sputtering target of material to be deposited is subjected in the coating chamber to power pulses, which transfer an amount of energy to the sputtering target that exceeds a maximum power density in the pulse of ≥ 500 W/cm².

2. Method according to Claim 1, **characterised in that**, during the deposition of the functional layer, each sputtering target of material to be deposited is subjected in the coating chamber to power pulses, which transfer an amount of energy to the sputtering target that exceeds a maximum power density in the pulse of ≥ 1000 W / cm².

3. Method according to Claim 1 or 2, **characterised in that**, during the deposition of the functional layer, each sputtering target of material to be deposited is subjected in the coating chamber to power pulses having discharge current densities in the pulse of ≥ 1 A/cm², preferably ≥ 3 A/cm².

4. Method according to any one of the preceding claims, **characterised in that** the single-layer or multi-layer functional layer has an overall thickness of 1 µm to 10 µm.

5. Method according to any one of the preceding claims, **characterised in that** the single-layer or multi-layer covering layer has an overall thickness of 50 nm to 500 nm.

6. Method according to any one of the preceding claims, **characterised in that** the functional layer consists of one or more layers of TiₓAl₁₋ₓN with 0.35≤X≤0.45.

7. Method according to any one of the preceding claims, **characterised in that** the functional layer has a Vickers hardness in the range of 2500 HV to 4500 HV.

8. Method according to any one of the preceding claims, **characterised in that** the functional layer has a modulus of elasticity (E modulus) in the range of 350 GPa to 550 GPa.

9. Method according to any one of the preceding claims, **characterised in that** the substrate consisting of carbide has a composition of 9 to 14 wt% Co, and 0 to 1.5 wt% cubic carbides selected from TiC, TaC and NbC and the rest is WC.

10. Method according to any one of the preceding claims, **characterised in that** the substrate consisting of carbide comprises WC and the WC has an average grain size of 0.5 to 5 µm.

## Revendications

1. Procédé de production d'une fraise en carbure monobloc à revêtement comprenant les étapes au cours desquelles : un substrat en carbure est doté d'un revêtement multicouche appliqué par dépôt physique en phase vapeur au moins sur les zones de surface entrant en contact avec une pièce à usiner lors du fraisage, le revêtement multicouche comprenant une couche de fonctionnelle unique ou multiple, déposée directement sur la surface du substrat, et une couche de recouvrement unique ou multiple déposée par-dessus, étant entendu que
la couche fonctionnelle est déposée par pulvérisation cathodique magnétron pulsée à haute puissance (HIPIMS) d'une ou plusieurs couches de TiₓAl₁₋ₓN, où 0,3 ≤ X≤ 0,55, selon une épaisseur totale de 1 µm à 15 µm, et
la couche de recouvrement est déposée par pulvérisation cathodique magnétron pulsée à haute puissance (HIPIMS) d'une ou plusieurs couches de ZrN selon une épaisseur totale allant de 50 nm à 1 µm ; lors du dépôt de la couche fonctionnelle, chaque cible de pulvérisation en matière à déposer étant soumise, dans l'enceinte de revêtement, à des impulsions de puissance qui transmettent à la cible de pulvérisation une quantité d'énergie qui est supérieure à une densité de puissance maximale dans l'impulsion de ≥ 500 W/cm².

2. Procédé selon la revendication 1, **caractérisé en ce que**, lors du dépôt de la couche fonctionnelle, chaque cible de pulvérisation en matière à pulvériser est soumise, dans l'enceinte de revêtement, à des impulsions de puissance qui transmettent à la cible de pulvérisation une quantité d'énergie qui est supérieure à une densité de puissance maximale dans l'impulsion de ≥ 1000 W/cm².

3. Procédé selon la revendication 1 ou 2, **caractérisé en ce que**, lors du dépôt de la couche fonctionnelle, chaque cible de pulvérisation en matière à pulvériser est soumise, dans l'enceinte de revêtement, à des impulsions de puissance dont la densité de courant de décharge dans l'impulsion est de ≥ 1 A/cm², de préférence de ≥ 3 A/cm².

4. Procédé selon l'une des revendications précédentes, **caractérisé en ce que** la couche fonctionnelle unique ou multiple présente une épaisseur totale allant de 1 µm à 10 µm.

5. Procédé selon l'une des revendications précédentes, **caractérisé en ce que** la couche de recouvrement unique ou multiple présente une épaisseur totale allant de 50 nm à 500 nm.

6. Procédé selon l'une des revendications précédentes, **caractérisé en ce que** la couche fonctionnelle se compose d'une ou plusieurs couches de TiₓAl₁₋ₓN, où 0,35≤X≤0,45.

7. Procédé selon l'une des revendications précédentes, **caractérisé en ce que** la couche fonctionnelle présente une dureté Vickers située dans la plage de 2500 HV à 4500 HV.

8. Procédé selon l'une des revendications précédentes, **caractérisé en ce que** la couche fonctionnelle présente un module d'élasticité (module E) situé dans la plage de 350 GPa à 550 GPa.

9. Procédé selon l'une des revendications précédentes, **caractérisé en ce que** le substrat en carbure présente une composition comprenant de 9 à 14 % en poids de Co et de 0 à 1,5 % en poids de carbures cubiques choisis parmi TiC, TaC et NbC, le reste consistant en WC.

10. Procédé selon l'une des revendications précédentes, **caractérisé en ce que** le substrat en carbure présente du WC et le WC possède une granulométrie moyenne allant de 0,5 à 5 µm.
